# EUROPEAN PATENT SPECIFICATION

(11) **EP 1 695 370 B1**
(45) Date of publication and mention of the grant of the patent: **08.12.2010**
(21) Application number: 04806048.7
(22) Date of filing: 14.12.2004
(51) Int. Cl.: H01J 37/32

(54) **APPARATUS AND METHOD FOR PLASMA PROCESSING**
VORRICHTUNG UND VERFAHREN ZUR PLASMAVERARBEITUNG
DISPOSITIF ET PROCEDE POUR LE TRAITEMENT AU PLASMA

(30) Priority: 19.12.2003 GB 0329460
(43) Date of publication of application: 30.08.2006
(73) Proprietor: Oxford Instruments Plasma Technology Limited, Witney, Oxfordshire OX8 1TL (GB)
(72) Inventor: SINGH, Nityalendra, Bradley Stoke BS32 0HF (GB); CROAD, Roger, James, Wilshire, Bridgwater, Somerset TA6 7HX (GB)
(74) Representative: Lord, Michael
(86) International application number: PCT/GB2004/005230
(87) International publication number: WO 2005/059948

(56) References cited:
- US-A- 5 158 644
- US-A- 5 766 364
- US-A- 5 968 379
- US-A1- 2001 001 954
- US-B1- 6 538 872
- US-B1- 6 569 257

## Description

This invention relates to an apparatus and method for plasma processing including plasma cleaning, for example in the field of low pressure plasma processing at high temperatures.

Low pressure plasma processing techniques are widely used in the electronics industry to deposit materials such as conductors, insulators, or semiconductors on a target substrate. The target substrate is usually a silicon wafer and is placed on a heated electrode inside a chamber under vacuum. Plasma enhanced chemical vapour deposition (PECVD) is a low pressure deposition process whereby the reactivity of the plasma is used to accelerate thin film deposition on a heated substrate in a vacuum process chamber. A PECVD process is usually performed at substrate temperatures in the range 200 to 800°C. During this process, the plasma reaction products, apart from depositing on the target substrate, collect on undesirable areas such as the chamber walls, electrode surface(s) and other parts of the apparatus within the chamber. In repeated thin film deposition processes, such deposits gradually accumulate inside the apparatus. Typically, such deposits lose their thermal stability as their thickness increases and exfoliate from areas such as the inner walls and start floating as particles inside the reaction chamber. The particles then adhere onto the target substrate as foreign objects and cause impurity contamination, which eventually results in defects. To minimize the effect of these unwanted deposits, plasma cleaning is carried out.

A generally preferred method of cleaning deposition tools after the deposition of insulators (for example, such as silicon oxide or silicon nitride) involves the use of fluorinated compounds. For example, gases such as CF4, C2F6, C3F8, SF6 and NF3 are used to generate active fluorine radicals by a plasma decomposition reaction. The fluorine radicals etch away the unwanted deposits in the form of volatile gaseous compounds, which are then pumped out and away from the processing chamber. However, the chemically active fluorine ions and radicals in the plasma remove not only the unwanted deposits on components such as the showerhead and chamber walls, but also start attacking the heated electrode on which the substrate is placed for processing. This results in a loss in the thermal performance of the electrode and loss of electrical contact in the case of metallic electrodes.

The heated electrodes used in PECVD can be categorized according to their low and high temperature operating modes. For low temperature operation up to 400°C, a material such as aluminium is used as the electrode material. For higher temperatures, greater than 400°C, a material such as stainless steel is usually used as electrode material for high temperature deposition. Note that aluminium electrodes are limited to operating below 480°C (due to their thermal properties) whereas stainless steel and ceramics such as AlN can be used in a wider temperature range.

Unfortunately aluminium reacts with the fluorine active radicals to form aluminium fluoride, which loses its thermal stability as the temperature is increased beyond 200°C and ends up in the chamber as a yellow brown deposit. Also as the deposition thickness increases in the chamber, the aluminium by-products flake off and fall onto the substrate causing irreversible contamination of the substrate.

The main problem with stainless steel electrodes is their incompatibility to fluorine radicals at temperatures above 200°C. Therefore, when a stainless steel electrode is used for a deposition process at 700°C, plasma cleaning is typically only performed once the electrode has been allowed to cool down to 200°C or less. This leads to delays in the use of the apparatus particularly since stainless steel has a low thermal conductivity implying a very long cooling time that affects productivity in a manufacturing environment. Furthermore, if too much deposition occurs, the films will flake off when cooling to the cleaning temperature, and become much more difficult to remove by plasma cleaning.

The cooling step is included in the cleaning process to protect the stainless steel from being attacked and to avoid an additional source of contamination resulting from the precipitation at high temperatures of compounds containing chromium, manganese and so on, within the steel. In addition, the carbon content of stainless steel is high enough to produce embrittlement at high temperatures, thereby reducing the thermal contact with the processing wafer due to damage.

Hence, the electrode performance and lifetime are severely restricted. Ceramics such as AlN have been used as the high temperature material but their use is not without problems, notably the high material procurement costs and machining difficulties. Also in a plasma apparatus, the electrode is preferably an electrical conductor, so ceramics cannot be used alone.

Consequently, a balance is required between efficient cleaning methods and plasma processing equipment both at low and high temperatures without jeopardising system performance, uptime and process capability.

US2001/0001954 discloses a semiconductor device manufacturing apparatus having a reaction chamber, an upper electrode and a heated substrate holder formed from a nickel-based alloy.

In accordance with a first aspect of the present invention we provide plasma processing apparatus comprising:-
a chamber within which a substrate is processed in use;
a first electrode formed from a nickel alloy having substantially planar upper and lower surfaces, wherein the substrate is placed for processing upon the upper surface of the first electrode;
a second electrode;
a heater for heating at least the first electrode to a processing temperature; and
a power supply system arranged to cause an electrical discharge between the said first and second electrodes so as to produce the plasma in the chamber from one or more gases supplied to the chamber,
wherein the nickel alloy of the first electrode has nickel as the major constituent; and, wherein the heater comprises one or more heating members arranged in a substantially planar manner, the heater and electrode forming an assembly such that the parts of the one or more heating members that are closest to the said upper surface of the first electrode, define a first plane that is separated from the upper surface by a distance Y, the parts of the one or more heating members that are furthest from the said upper surface of the first electrode, define a second plane, wherein the separation of the first and second planes defines a heater thickness X, characterized in that : Y lies in the range 1.2X to 3X.

We have realised that many of the problems associated with former known systems are alleviated by the use of an electrode formed from a nickel alloy. However, the substitution of nickel for prior aluminium or stainless steel electrodes, whilst leading to improve results, does not fully provide the desired high temperature behaviour. We have also realised that the relative thicknesses of the heater and electrode components are also important in providing the desired temperature properties, particularly at high temperatures. The apparatus according to the first aspect of the invention however provides this improved behaviour for depositing films up to temperatures of at least 800°C. Further, it also provides the ability to perform high quality plasma cleaning at elevated temperatures, particularly those in excess of 400°C. It should be noted that the plasma processing according to the invention includes conventional processes such as deposition and etching. It also includes plasma cleaning.

The present invention contemplates that, preferably, the heater is positioned within the first electrode. However, in some situations, it may be positioned beneath the electrode itself and in thermal contact with it. When the heater is arranged within the first electrode, the second plane is preferably separated from the lower surface of the said first electrode by a distance W. In this case, the total thickness Z of the electrode and heater assembly is given by Y + W + X and in this case Z preferably lies in the range 2Y to 2.5Y and Y lies in the range 1.2X to 3X.

These distances are to be chosen so as to provide two functions;
1) Rapid heating up of the electrode by minimising the effect of thermal inertia which is directly related to the thickness of the metal and notably the distance Y;
2) Rapid cooling of the surface temperature to perform plasma cleaning at high temperatures. This is also linked to Y.

It will be appreciated that various different heater configurations can be provided, although typically each of these is arranged so as to provide as uniform a heating effect as possible across the expanse of the upper surface of the electrode and therefore of the substrate. The heater may therefore comprise various coils within the electrode, or be in the form of a plate within it. The heater may therefore have one or more tubular or rod-like members which are suitable for use with Y taking any value in the 1.2X to 3X range. Other heater configurations include a "thin foil" type which may be profiled, in which case a value of Y closer to the lower value of 1.2X is preferred.

The primary purpose of the heater is to heat the upper surface of the electrode and therefore, whether or not the heater is placed within or beneath the electrode, the apparatus preferably further comprises a heat shield, positioned at or adjacent the bottom surface of the assembly so as to reduce heat dissipation from the bottom part of the assembly. In the case of a heater within the electrode itself, the bottom part of the electrode having the thickness W can therefore act as such a heat shield.

Various nickel alloys may be used with advantage for the electrode due to their corrosion resistance, high thermal conductivity, low emissivity and low electrical resistivity. Whereas all such nickel alloys comprises nickel as at least the major constituent, preferably high purity nickel alloys are used, that is having a nickel content of at least 99%, such as is provided by pure nickel or the alloys nickel 201 or nickel 400. Nickel 201 typically has a thermal conductivity of 80W/mK, electrical resistivity of 8.5e-6 ohmcm and an emissivity of 0.08 (polished - 400°C to 0.19 (unoxidized at 1000°C).

The various relative dimensions Z,X,Y and W, are chosen so as to provide the particular desirable thermal performance across different wafer sizes. For example, this invention is capable of providing excellent temperature uniformity across a 200 mm silicon wafer. It is desirable that the alloy, the dimensions and the heating devices used are capable of heating the electrode with the substrate thereupon to preferably 700 °C from ambient temperature within substantially one hour or less, preferably about 45 minutes or less. The natural cooling of the first electrode from high temperatures is also of great importance to the invention and preferably the first electrode is adapted to cool in use from 700°C to 400°C in less than 30 minutes, preferably between 15 and 20 minutes or less. Such short heating and cooling times are important since they increase the operational speed of the process as a whole. This is effected by the combination of the use of a nickel alloy with the dimensional ranges discussed above.

The apparatus can be used firstly in a conventional sense for numerous standard plasma processing operations. In this case, the heating and cooling parameters/properties of the electrode are particularly beneficial for the rapid performance of the process, and in obtaining a very homogeneous temperature distribution across the electrode surface. This in turn is manifested in the temperature distribution in the substrate placed in thermal contact with it.

The apparatus is also particularly beneficial for use in conjunction with a plasma cleaning method and thus in accordance with a second aspect of the present invention we provide a method of plasma cleaning the contents of a plasma processing chamber according to the first aspect of the invention, the method comprising providing a fluorine-containing gas in the said chamber whilst the said chamber is at an elevated temperature such that the chamber is cleaned by the action of the fluorine-containing gas.

The apparatus according to the first aspect of the invention is particularly advantageous when using fluorine-containing gases as a cleaning gas since nickel alloys are particularly resistant to degradation from fluorine radicals in such cleaning plasmas. In principle, the cleaning method according to the second aspect of the invention can be performed in a stand-alone sense such that the chamber may be heated from a cold condition by the heating of the electrode to an elevated temperature followed by the striking of a plasma using the fluorine-containing gas. Typically however, the method will be used directly following a deposition step and therefore the method preferably further comprises, prior to the introduction of the fluorine containing gas, using the chamber to perform plasma processing upon a substrate heated to a processing temperature. In any case, the chamber may be maintained at a predetermined temperature during cleaning, or alternatively, it may be allowed to cool to a lower temperature naturally, in which case the lower temperature may be ambient.

The elevated temperature may therefore at least initially comprise substantially the processing temperature. This elevated temperature may be in the range 200°C to 800°C and preferably is in the range 400°C to 700°C. A temperature of 700°C is beneficial for the processing of polysilicon, atomic layers and so on. Foil heaters can be used for processing to temperatures of between 500°C and 600°C although they tend to be more expensive than tubular heaters.

Various cleaning gases may be used to provide the fluorine-containing gas. Typically a gas such as CF4 may be used as a precursor and preferably the fluorine-containing gas comprises a mixture of CF4 and 02 in the respective ratios of substantially 80% to 20% by volume. Preferably the flow rate of the gas is about 150 standard cubic centimetres per minute. The plasma cleaning step has been found to be particularly beneficial using a dual frequency plasma, that is, a low frequency component having a frequency between 50 and 450 KHz, together with a high frequency component at 13.56 MHz. Typically the power range is between 50 and 300 watts.

As mentioned above, the apparatus may be used to perform various known plasma processing methods, and therefore in accordance with a third aspect of the present invention, we provide a method of plasma processing comprising positioning a substrate in contact with the upper surface of the first electrode in a plasma processing chamber of apparatus according to the first aspect of the invention, supplying one or more process gases to the chamber and generating a plasma within the chamber from the process gases, using the first and second electrodes so as to plasma process the substrate.

Such plasma processes include deposition and etching processes, although are preferably for the deposition of insulators such as polysilicon, oxides and nitrides. These processes are preferably performed at elevated temperatures in the range 200°C to 800°C and preferably in the range 400°C to 700°C.

Some examples of a plasma processing apparatus and methods according to the present invention will now be described with reference to the accompanying drawings, in which:-
Figure 1 is a schematic illustration of an example plasma processing apparatus according to the invention;
Figure 2 shows a section through an electrode assembly according to the example;
Figure 3 shows a detailed view of the heater embedded in an electrode assembly according to the example;
Figure 4 shows measured temperature variations at different positions on a silicon wafer surface when heated using the example apparatus;
Figure 5 is a graph illustrating a typical temperature response of the electrode when heated in an assembly according to the example; and,
Figure 6 is a flow diagram of an example method according to the invention.

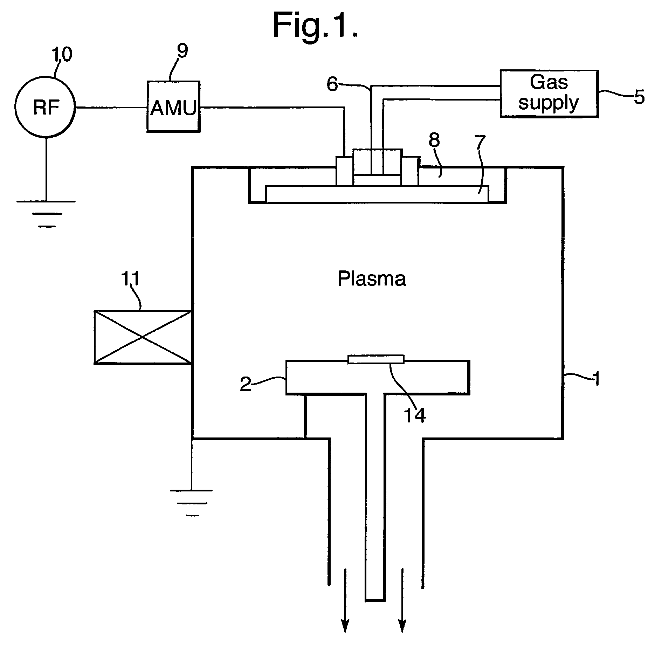

A schematic low pressure plasma processing system according to the invention is shown in Figure 1. This comprises a vacuum process chamber (plasma chamber) 1 within which is positioned an electrode assembly 2. This assembly comprises an electrode (first electrode) 3, together with a heater 4, the details of which are not shown in Figure 1. A gas delivery system 5 provides process and cleaning gases along a conduit 6 to a showerhead assembly 7 via a gas inlet assembly. A suitable gas inlet assembly is described in British patent application number 0326500. This comprises a second electrode 8 connected to an external impedance matching network 9 which in turn is connected to an RF generator 10. A loadlock apparatus 11 is provided for loading substrates in and out of the vacuum process chamber 1. A suitable loadlock apparatus is described in European Patent Publication EP-A-1217647.

At the base of the chamber, a pumpout port 13 is provided for evacuating the gases from the chamber via vacuum pumps and pressure control valves.

When in use, a substrate 14 is positioned upon the upper surface of the electrode assembly 2 using the loadlock apparatus 11. Depending on the process in question, either process or cleaning gases are provided from the gas delivery system 5 into the chamber 1 via the conduit 6 and showerhead assembly 7. A controlled low pressure, in the range 500 mTorr to 5000 mTorr, of the gases is provided within the chamber by the control of pumps and/or regulators connected to the pumpout port 13 and the gas delivery system 5. The substrate is heated to a processing temperature with the heater 4 (not shown in Figure 1).

A low pressure flow of gas is therefore established within the chamber, and the RF generator 10 and the matching network 9 are then operated so as to strike and maintain a plasma between the first electrode 3, and the second electrode 8. Whilst this is performed, the heated electrode is used to provide uniform heating to the substrate. In this case, the electrode 3 is manufactured from nickel-based alloy, (nickel 201 here) and having predefined dimensions as are discussed in more detail later. Other nickel alloys such as alloy 400 can also be used for this purpose, although nickel 201 is chosen for this particular example since it shows excellent corrosion resistance to halogens (and notably fluorine) at very high temperatures of around 700°C. This is advantageous since no significant by-products will be formed in the deposition of either insulating materials such as oxides using silane, or indeed metals such as titanium using chloride compounds. It should be noted for instance, that when exposed to dry fluorine under vacuum, the corrosion rate of nickel at temperatures in excess of 400°C is less than 0.1 mm per annum.

Such a corrosion rate is insignificant when compared with a stainless steel heated electrode. Nickel 201 also provides advantage due to its high electrical and thermal conductivity. In addition, due to its low carbon content (of less than 0.02 weight percent carbon) nickel 201 is resistant to the precipitation of graphite particles and therefore it can be used at temperatures even up to 800C for extended periods. Furthermore, nickel shows good resistance to performance degradation caused by periodical thermo-cycling between low and high temperatures.

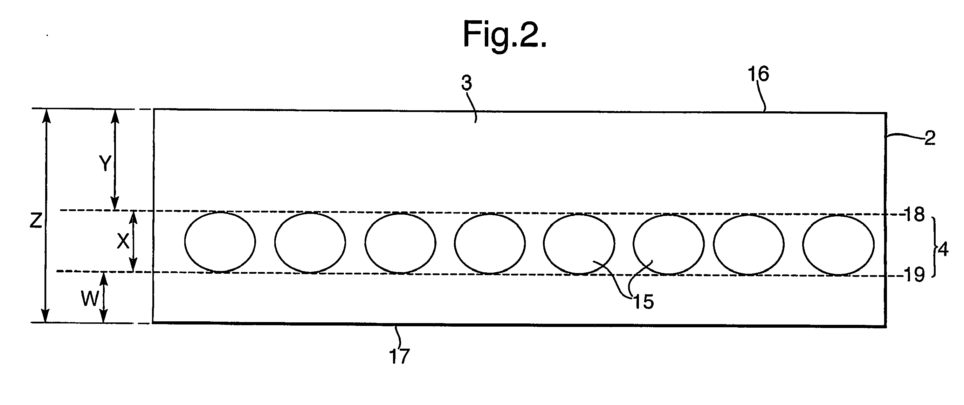

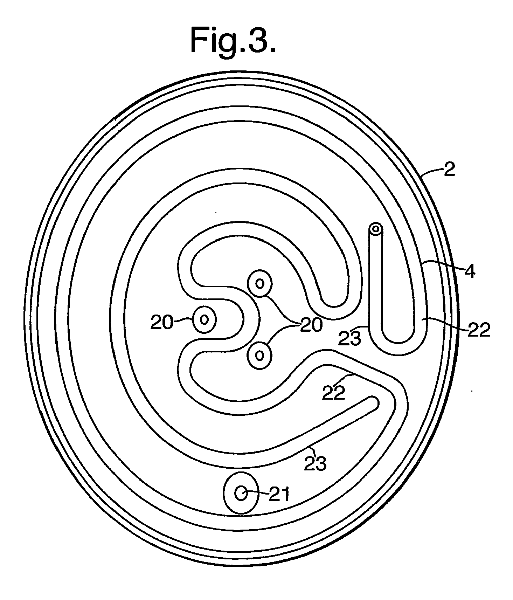

A schematic cross-section of the electrode assembly 2 is shown in Figure 2. Here the heater comprises a number of heating elements (members) 15 which are connected in a planar coil arrangement as shown in Figure 3. It can be seen in Figure 2, that these are positioned at just beneath the mid-point in the vertical direction between the upper 16 and uppermost lower 17 surfaces of the electrode 3. The uppermost parts closest to the upper surface 16 of the electrode 3, define a first plane 18, whereas the lowermost parts define a second plane 19. As is shown in Figure 2, the dimension Y represents the distance between the first plane 18 and upper surface 16 of the electrode, the dimension W defines the shortest distance between the plane 19 (second plane) and the lower surface 17 of the electrode 3. The thickness of the heating elements 15 is therefore the distance between the first and second planes 18,19, this being denoted by X, whereas the total thickness of the electrode assembly 2 is given by Z, which has dimensions equal to the sum of W, X and Y.

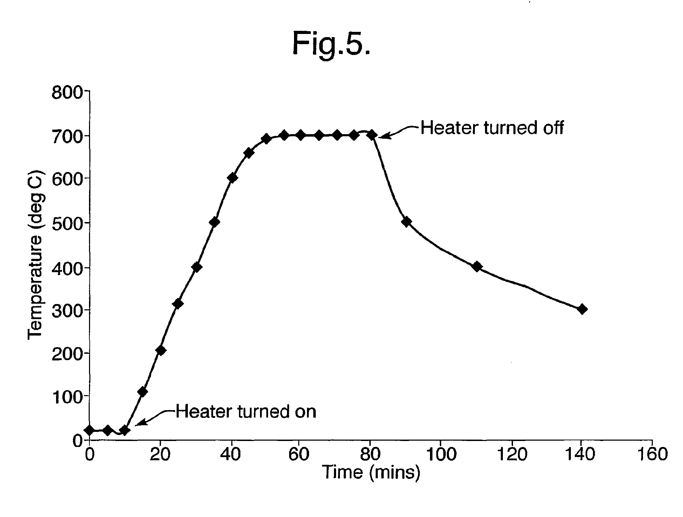

It has been found that various respective ratios between these variables allow an efficient cleaning process with no effect on the thermal performance of the electrode assembly 2. The dimension Y, ratio Z:Y and Y:X are important as they are directly related to the thermal performance of the electrode assembly. Importantly the heating up and cooling down times of the electrode assembly are a function of the values of these parameters. The heating up of the electrode from 20 deg C to 700 deg C in this case takes,about 45 minutes (Figure 5). It takes about 30 minutes for the electrode to cool down from 700 deg C to 400 deg C as also shown in Figure 5. We have found that Z should be between 2 and 2.5 times Y, and Y is also in the range 1.2 to 3 times X. It is desirable that the "relaxation time", that is the cooling time, is very rapid, this being particularly the case for the deposition of thick insulator films of up to 100 micrometers in thickness. The selection of Y is important as such to maintain rapid relaxation times or at least maintain the relaxation time from 700°C to 400°C to within 30 minutes irrespective of the change in the thermal properties of the electrode surface due to the deposition of insulating films. The parameter Y is also important for temperature uniformity as it directly influences the thermal characters of the electrode assembly and hence the processing temperature. We have found that the following dimensions are particularly beneficial: Z = 32 mm, W=10 mm, X= 6 mm, Y= 16 mm . The platen has a diameter of 240 mm. The limits of the dimensions (in mm) are as follows: 30 <Z< 40, 6<W<12, X=6mm (fixed in this example), 12<Y<20 and for a heater rated to minimum 2.8 kW (230 V/13 A).

Figure 3 shows a practical layout of the cross section of the assembly 2 (platen) with the heater 4 layout also indicated. The heating element is laid out in an approximately concentric form in a Nickel 201 metal plate. The element diameter is 0.260 inches (6.6 mm) and is rated to 2850 W (240 V). The element has been laid out with the need to obtain an across 8 inch (200mm) wafer temperature uniformity of less than +/- 1% at 700 deg C. Finite element analysis has been performed to this end using modelling software. Important aspects that determine temperature uniformity and electrode performance such as the type and characteristic of the material used (thermal conductivity, electrical resistivity and emissivity), the actual physical shape of the metal part and the heater placement within the part (cast-in type design) have been considered. The latter is important, as intimate contact is required to optimise heat transfer and also to increase heater lifetime by reducing hot spots. As shown in Figure 3, the heater has been laid out in a concentric pattern in grooves in the surrounding metal part to improve heat transfer to the surface of the electrode. The metal piece has three apertures 20 in the centre through which three pins pass to allow the substrate wafers to be moved up and down. A further aperture 21 is located between the two most outer loops and used for a K type thermocouple. The heater parts labelled 22 are important as they overcome the cold spots generated by joining the heater legs to the element. The heater legs are joined at positions 23.

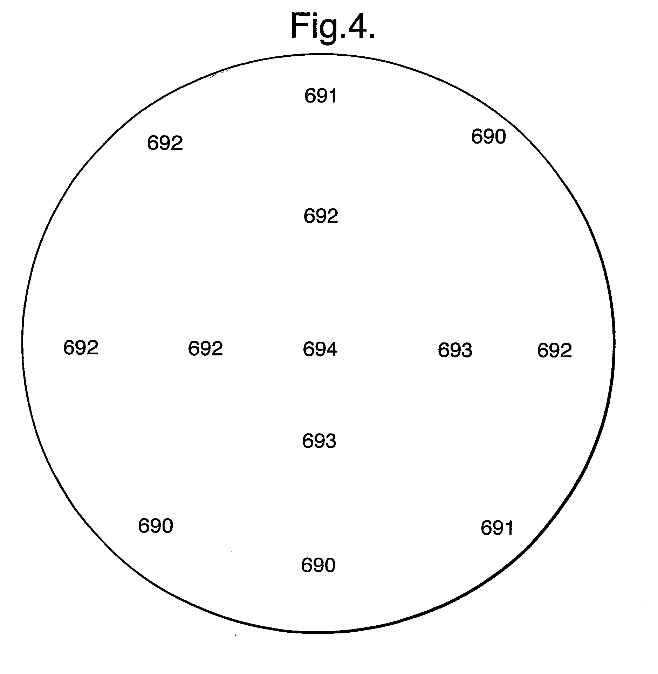

Using an electrode assembly 2 according to this example, the temperature distribution across an 8 inch, 200mm instrumented wafer (embedded with thermocouples) at 700°C electrode temperature, was measured. The respective values of measured temperature in Celsius are shown in Figure 4. As is demonstrated, the temperature uniformity is less than ± 0.3%. Not only does the apparatus according to the invention therefore provide the ability to rapidly heat the electrode to its operational temperature such as 700°C, it also provides for important rapid cooling from 700°C to a lower temperature, such as 400°C to 500°C. This is also particularly important as it further increases the lifetime of the electrode assembly 2 by reducing significantly the corrosion rate of nickel 201, which is temperature dependent. This is also important as at these temperatures exfoliation does not happen as the temperature gradient is still high to maintain the particles adhesion. However, at temperatures of 200°C or less, the particles lose their adhesion and start floating in the chamber. Therefore, a pre-defined lower temperature in the range 400°C to 500°C is important as to maintain minimum contamination levels. The typical heating and cooling behaviour of the assembly described in this example is shown in Figure 5.

In the above example therefore, the values provided for the X, Y, W and Z variables, act together to produce a very useful practical system.

As an alternative to the example described, it is also possible to effectively remove the bottom electrode portion of thickness W and therefore to provide a bottom-heated electrode, where the heater may form all or part of the base of the electrode. This may be attached beneath the electrode and in good thermal contact with it. The disadvantage of such a system is that this causes unwanted heat losses from beneath the electrode and therefore it is desirable in such a case to provide an additional heat shield that may be formed of a similar material to the electrode or a higher power rated heater. This heat shield may then act in a similar manner to one of the functions of the material of thickness W discussed earlier, namely by reducing heat dissipation in a downward direction. Therefore, more of the generated heat is directed efficiently towards the substrate and as a result, the heating time can be reduced.

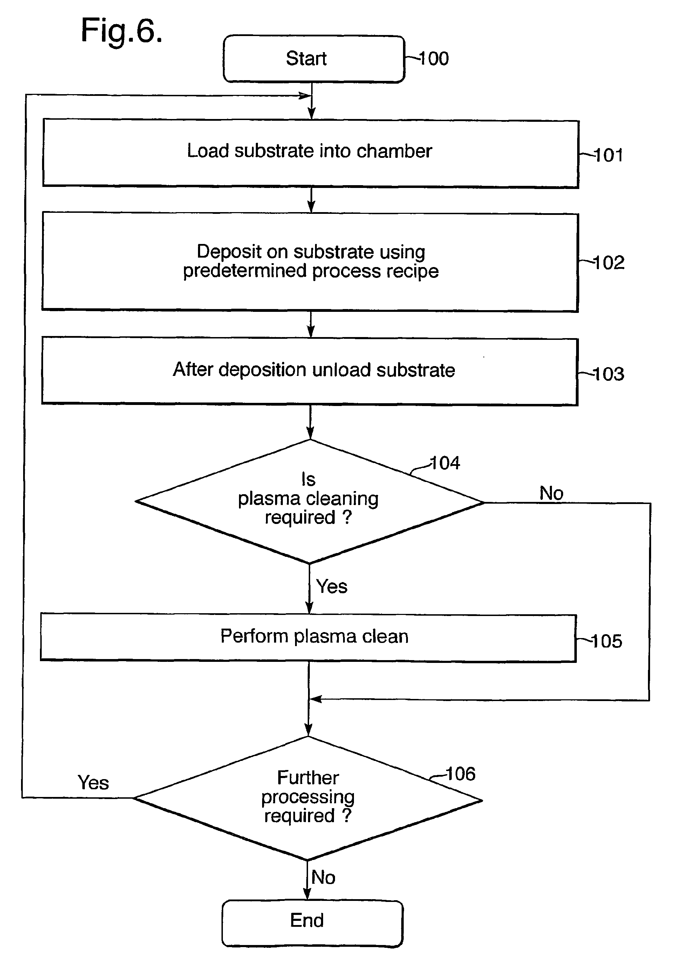

A method of operating the example of apparatus according to the embodiment described earlier (in which the heater is within the electrode itself), is now described with reference to Figure 6. The process now described is a combined deposition and subsequent cleaning process although it will be appreciated that the apparatus may be used for separate deposition and cleaning processes as well.

The method begins at step 100. A silicon or other suitable substrate is loaded into the chamber 1 using the loadlock 11 when under vacuum at step 101. Subsequently at step 102, a deposition process is performed in which a plasma is generated within the chamber, this being generated using the first 3 and second 8 electrodes. Once the deposition process has finished, the substrate contains a film of predetermined thickness and chemical composition. However, not only is the substrate provided with such a film, unfortunately other parts of the plasma processing chamber 1 are inevitably also provided with such a film. Following deposition, the substrate is removed from the chamber via the loadlock 11 at step 103. Subsequently at step 104, a decision is made as to whether cleaning of the internal chamber is required. This decision is based upon a visual inspection, or after a number of process cycles or could be determined using optical instrumentation such as CCD camera. If no such cleaning is required then the method continues to step 106 where a further decision is made regarding whether or not further processing using the apparatus is required. If it is, then the method may then return to step 101 where a further substrate is loaded to the chamber. This newly loaded substrate may indeed be a different substrate or the same substrate, depending upon the process in question. If however at step 104 plasma cleaning is required, then the method proceeds directly to step 105. Advantageously, with the apparatus according to the present invention, the plasma cleaning can be carried out at high temperatures, these including the deposition or other process temperature used within step 102, and notably immediately after such steps if desired.

The apparatus allows the combined advantage of using a metal electrode without the need for cooling the electrode down to a lower temperature for cleaning. However, as with known metal electrodes, it is of course possible to allow the electrode to cool prior to cleaning. A distinct advantage of cleaning without an intermediate cooling step is that valuable processing time is saved as it may take more than four hours for a traditional electrode to cool to 200°C.

A typical cleaning temperature in the present case is 700°C. At step 105, whilst the electrode is at about this temperature, the predetermined gas flow mixture of CF4/02 is flowed into the chamber under high pressure from the gas delivery system 5. The pressure in this case may be up to 5 Torr. A high frequency plasma in the range 50 to 450 KHz and/or at 13.56 MHz (preferably both) with a power range varying from 50 to 300 watts in each case, is used to generate the plasma for cleaning. The electrode is maintained at about 700°C using the heater 4 during the cleaning.

In an alternative example, step 105 is performed without maintaining the electrode temperature. Of course, it will be necessary for the system to already be at an elevated temperature and typically such a temperature is provided as a result of previous processing steps (such as steps 101 to 103). The plasma cleaning therefore occurs whilst the temperature within the chamber, and particularly that of the electrode, gradually reduces to a lower temperature, for example 400C. As the temperature decays, the reactivity of the surfaces to the fluorine plasma is reduced by a factor of at least 10 times. The cooling is dependent upon the specific temperatures chosen, the nickel alloy in question and the electrode assembly dimensions, particularly dimension Y.

In a further example, the plasma cleaning step 105 can be performed at a temperature which is reduced and is maintained at a level which is lower than the processing temperature in earlier steps such as step 102. Again, as in the previous examples, low and/or high frequency plasmas may be generated with similar power.

There are therefore various alternative cleaning strategies. However, each of these either involves plasma processing whilst the electrode is maintained at a fixed temperature (which may be equal to that of the processing temperature in a processing step such as 102), or during natural cooling following the heating to an elevated temperature such as that processing temperature.

A combination of the use of such a process with the apparatus according to the invention therefore provides practical advantages, particularly in terms of reducing the overall down time of the apparatus.

As a clean plasma will etch any material, it is the rate of this attack that requires control. This invention provides a rugged and reliable electrode with a long lifetime. As such, the selection of a nickel alloy, process conditions and the dimensions (particularly Y for managing the corrosion rate and maintaining the mechanical and electrical contact with the wafer) are very important. The mechanical contact is important to provide contact between wafer and electrode under changing temperatures and deposited films.

## Claims

1. Plasma processing apparatus comprising:-
a chamber within which a substrate is processed in use;
a first electrode formed from a nickel alloy having substantially planar upper and lower surfaces, wherein the substrate is placed for processing upon the upper surface of the first electrode;
a second electrode;
a heater for heating at least the first electrode to a processing temperature; and
a power supply system arranged to cause an electrical discharge between the said first and second electrodes so as to produce the plasma in the chamber from one or more gases supplied to the chamber,
wherein the nickel alloy of the first electrode has nickel as the major constituent; and,
wherein the heater comprises one or more heating members arranged in a substantially planar manner, the heater and electrode forming an assembly such that the parts of the one or more heating members that are closest to the said upper surface of the first electrode, define a first plane that is separated from the upper surface by a distance Y, the parts of the one or more heating members that are furthest from the said upper surface of the first electrode, define a second plane, wherein the separation of the first and second planes defines a heater thickness X, **characterized in that** Y lies in the range 1.2X to 3X.

2. Apparatus according to claim 1, wherein the heater is arranged within the first electrode and wherein the second plane is separated from the lower surface of the electrode by a distance W, wherein a thickness Z of the combined electrode and heater assembly is given by Y+W+X; and wherein Z lies in the range 2Y to 2.5Y and Y lies in the range 1.2X to 3X.

3. Apparatus according to claim 1 or claim 2, further comprising a heat shield, positioned at the bottom surface of the assembly so as to reduce heat dissipation from the bottom part of the assembly.

4. Apparatus according to any of the preceding claims, wherein the nickel alloy comprises at least 99% by weight of nickel.

5. Apparatus according to any of the preceding claims, wherein the heater comprises a tubular, rod-like or foil heater.

6. A method of plasma cleaning the contents of a plasma processing chamber of the plasma processing apparatus according to any of the preceding claims, the method comprising providing a fluorine-containing gas in the said chamber whilst the said first electrode is at an elevated temperature such that the first electrode is cleaned by the action of the fluorine-containing gas.

7. A method according to claim 6, wherein the first electrode is heated to 700°C from ambient temperature within substantially one hour or less, preferably 45 minutes or less.

8. A method according to claim 6, wherein the first electrode is cooled in use from 700 to 400°C in less than 30 minutes.

9. A method according to claim 6, wherein the method comprises, prior to the introduction of the gas, using the chamber to perform plasma processing upon a substrate heated to a processing temperature.

10. A method according to any of claims 6 to 9, wherein the first electrode is maintained at a predetermined temperature during cleaning.

11. A method according to any of claims 6 to 10, wherein the first electrode is allowed to cool during cleaning.

12. A method according to any of claims 6 to 11, wherein the elevated temperature is at least initially at substantially the processing temperature.

13. A method according to any of claims 6 to 12, wherein the elevated temperature is in the range 200°C to 800°C.

14. A method according to claim 13, wherein the temperature is in the range 400°C to 700°C.

15. A method according to any of claims 6 to 14, wherein the fluorine-containing gas comprises a mixture of CF4 and 02 in the respective ratios of 80% to 20% by volume.

16. A method according to any of claims 6 to 15, wherein the flow rate of the fluorine-containing gas is 150 standard cubic centimetres per minute.

17. A method according to any of claims 6 to 16, wherein the plasma cleaning step is performed using a low frequency component of between 50kHz and 450 kHz, and/or high frequency component of 13.56 MHz.

18. A method according to any of claims 6 to 17, wherein the plasma power range is between 50W and 300W.

19. A method of plasma processing comprising positioning a substrate in contact with the upper surface of the first electrode in a plasma processing chamber of plasma processing apparatus according to any of claims 1 to 5, supplying one or more process gases to the chamber and generating a plasma within the chamber from the process gas(es), using the first and second electrodes so as to plasma process the substrate.

20. A method according to any of claims 6 to 19, wherein the plasma process comprises a deposition or etching process.

21. A method according to any of claims 6 to 20, wherein the deposition is of an electrically insulating material.

## Patentansprüche

1. Plasmaverarbeitungsvorrichtung, umfassend:
eine Kammer, innerhalb der ein Substrat in Gebrauch verarbeitet wird;
eine aus einer Nickellegierung gebildete erste Elektrode mit im Wesentlichen planaren oberen und unteren Flächen, wobei das Substrat zur Verarbeitung auf die obere Fläche der ersten Elektrode platziert wird;
eine zweite Elektrode;
eine Heizeinrichtung zum Aufheizen zumindest der ersten Elektrode auf eine Verarbeitungstemperatur; und
ein Stromversorgungssystem, das eingerichtet ist, eine elektrische Entladung zwischen den besagten ersten und zweiten Elektroden zu bewirken, um das Plasma in der Kammer aus einem oder mehreren Gas(en) zu produzieren, das (die) der Kammer zugeführt werden,
wobei die Nickellegierung der ersten Elektrode Nickel als den Hauptbestandteil aufweist; und,
wobei die Heizeinrichtung ein oder mehrere Heizelemente umfasst, die in einer im Wesentlichen planaren Weise angeordnet sind, wobei die Heizvorrichtung und die Elektrode eine Baugruppe derartig bilden, dass die Teile des einen Heizelements oder der mehreren Heizelemente, das bzw. die der besagten oberen Fläche der ersten Elektrode am nächsten sind, eine erste Ebene definieren, die von der oberen Fläche durch einen Abstand Y getrennt ist, wobei die Teile des einen Heizelements oder der mehreren Heizelemente, das bzw. die von der besagten oberen Fläche der ersten Elektrode am weitesten entfernt sind, eine zweite Ebene definieren, wobei die Trennung der ersten und zweiten Ebenen eine Heizeinrichtungsdicke X definiert, **dadurch gekennzeichnet, dass** Y im Bereich 1,2X bis 3X liegt.

2. Vorrichtung nach Anspruch 1, wobei die Heizeinrichtung innerhalb der ersten Elektrode angeordnet ist und wobei die zweite Ebene von der unteren Fläche der Elektrode durch einen Abstand W getrennt ist, wobei eine Dicke Z der kombinierten Elektroden- und Heizbaugruppe durch Y+W+X gegeben ist; und, wobei Z im Bereich 2Y bis 2,5Y liegt und Y im Bereich 1,2X bis 3X liegt.

3. Vorrichtung nach Anspruch 1 oder Anspruch 2, die weiter ein Wärmeschild umfasst, das an der unteren Fläche der Baugruppe positioniert ist, um Wärmeableitung vom unteren Teil der Baugruppe zu reduzieren.

4. Vorrichtung nach einem beliebigen der vorhergehenden Ansprüche, wobei die Nickellegierung zumindest 99 Gew.-% Nickel umfasst.

5. Vorrichtung nach einem beliebigen der vorhergehenden Ansprüche, wobei die Heizeinrichtung eine rohrförmige, stabartige oder Folienheizeinrichtung umfasst.

6. Verfahren der Plasmareinigung des Inhalts einer Plasmaverarbeitungskammer der Plasmaverarbeitungsvorrichtung, nach einem beliebigen der vorhergehenden Ansprüche, wobei das Verfahren das Liefern eines fluorhaltigen Gases in die besagte Kammer umfasst, während sich besagte erste Elektrode auf einer hohen Temperatur befindet, sodass die erste Elektrode durch die Wirkung des fluorhaltigen Gases gereinigt wird.

7. Verfahren nach Anspruch 6, wobei die erste Elektrode ab einer Umgebungstemperatur im Wesentlichen innerhalb einer Stunde oder weniger, vorzugsweise 45 Minuten oder weniger auf 700 °C aufgeheizt wird.

8. Verfahren nach Anspruch 6, wobei die erste Elektrode in Gebrauch in weniger als 30 Minuten von 700 auf 400 °C gekühlt wird.

9. Verfahren nach Anspruch 6, wobei das Verfahren, vor der Einführung des Gases, Verwenden der Kammer zur Durchführung von Plasmaverarbeitung eines auf eine Verarbeitungstemperatur aufgeheizten Substrats umfasst.

10. Verfahren nach einem beliebigen der Ansprüche 6 bis 9, wobei die erste Elektrode, während der Reinigung, auf einer vorbestimmten Temperatur gehalten wird.

11. Verfahren nach einem beliebigen der Ansprüche 6 bis 10, wobei die erste Elektrode, während der Reinigung, abkühlen darf.

12. Verfahren nach einem beliebigen der Ansprüche 6 bis 11, wobei die hohe Temperatur zumindest anfänglich im Wesentlichen die Verarbeitungstemperatur ist.

13. Verfahren nach einem beliebigen der Ansprüche 6 bis 12, wobei die hohe Temperatur im Bereich 200 °C bis 800 °C liegt.

14. Verfahren nach Anspruch 13, wobei die Temperatur im Bereich 400 °C bis 700 °C liegt.

15. Verfahren nach einem beliebigen der Ansprüche 6 bis 14, wobei das fluorhaltige Gas eine Mischung aus CF4 und 02 in den jeweiligen Verhältnissen von 80% zu 20% volumenmäßig umfasst.

16. Verfahren nach einem beliebigen der Ansprüche 6 bis 15, wobei die Durchflussrate des fluorhaltigen Gases 150 Standardkubikzentimeter pro Minute beträgt.

17. Verfahren nach einem beliebigen der Ansprüche 6 bis 16, wobei der Plasmareinigungsschritt unter Einsatz einer Niederfrequenzkomponente von zwischen 50 kHz und 450 kHz und/oder einer Hochfrequenzkomponente von 13,56 MHz durchgeführt wird.

18. Verfahren nach einem beliebigen der Ansprüche 6 bis 17, wobei der Plasmaenergiebereich zwischen 50W und 300W liegt.

19. Plasmaverarbeitungsverfahren, das Positionieren eines Substrats in Kontakt mit der oberen Fläche der ersten Elektrode in einer Plasmaverarbeitungskammer der Plasmaverarbeitungsvorrichtung, nach einem der Ansprüche 1 bis 5, Lieferung eines oder mehrerer Gase zur Kammer und Generieren eines Plasmas innerhalb der Kammer aus dem (den) Verarbeitungsgas(en), unter Verwendung der ersten und zweiten Elektroden zur Plasmaverarbeitung des Substrats umfasst.

20. Verfahren nach einem der Ansprüche 6 bis 19, wobei der Plasmaprozess einen Abscheidungs- oder Ätzprozess umfasst.

21. Verfahren nach einem beliebigen der Ansprüche 6 bis 20, wobei die Abscheidung eines elektrisch isolierenden Materials ist.

## Revendications

1. Appareil de traitement au plasma comprenant:
une chambre dans laquelle est traité un substrat durant l'utilisation ;
une première électrode formée dans un alliage de nickel ayant des surfaces supérieure et inférieure sensiblement planes, le substrat étant placé pour son traitement sur la surface supérieure de la première électrode ;
une seconde électrode ;
un élément chauffant pour chauffer au moins la première électrode à une température de traitement ; et
un système d'alimentation électrique agencé pour provoque une décharge électrique entre lesdites première et seconde électrodes de façon à produire le plasma dans la chambre à partir d'un ou de plusieurs gaz délivrés dans la chambre ;
dans lequel l'alliage de nickel de la première électrode a comme constituant principal le nickel ; et
dans lequel l'élément chauffant comprend un ou plusieurs éléments chauffants agencés d'une manière sensiblement plane, l'élément chauffant et l'électrode formant un ensemble de telle sorte que les parties des un ou plusieurs éléments chauffants les plus proches de ladite surface supérieure de la première électrode définissent un premier plan séparé de la surface supérieure par une distance Y, les parties des un ou plusieurs éléments chauffants les plus éloignés de ladite surface supérieure de la première électrode définissent un second plan, la séparation des premier et second plans définissant une épaisseur d'élément chauffant X, **caractérisé en ce que** Y est compris dans la plage de 1,2X à 3X.

2. Appareil selon la revendication 1, dans lequel l'élément chauffant est agencé dans la première électrode et dans lequel le second plan est séparé de la surface inférieure de l'électrode par une distance W, une épaisseur Z de l'ensemble combiné d'électrode et d'élément chauffant étant donnée par Y+W+X ; et Z étant compris dans la plage de 2Y à 2,5Y et Y étant compris dans la plage de 1,2X à 3X.

3. Appareil selon la revendication 1 ou 2, comprenant en outre un écran thermique, placé au niveau de la surface de dessous de l'ensemble de façon à réduire la dissipation de chaleur depuis le fond de l'ensemble.

4. Appareil selon l'une quelconque des revendications précédentes, dans lequel l'alliage de nickel comprend au moins 99% en poids de nickel.

5. Appareil selon l'une quelconque des revendications précédentes, dans lequel l'élément chauffant comprend un élément chauffant tubulaire, en forme de tige ou de feuille.

6. Procédé de nettoyage au plasma du contenu d'une chambre de traitement au plasma de l'appareil de traitement au plasma, selon l'une quelconque des revendications précédentes, le procédé comprenant la fourniture d'un gaz à teneur en fluor dans ladite chambre tandis que ladite première électrode est à une température élevée de telle sorte que la première électrode soit nettoyée par l'action du gaz à teneur en fluor.

7. Procédé selon la revendication 6, dans lequel la première électrode est chauffée à 700°C à partir de la température ambiante en sensiblement une heure ou moins, de préférence 45 minutes ou moins.

8. Procédé selon la revendication 6, dans lequel la première électrode est refroidie durant l'utilisation de 700 à 400°C en moins de 30 minutes.

9. Procédé selon la revendication 6, le procédé comprenant, avant l'introduction du gaz l'utilisation de la chambre pour effectuer le traitement au plasma sur un substrat chauffé à une température de traitement.

10. Procédé selon l'une quelconque des revendications 6 à 9, dans lequel la première électrode est maintenue à une température prédéterminée durant le nettoyage.

11. Procédé selon l'une quelconque des revendications 6 à 10, dans lequel la première électrode est laissée à refroidir durant le nettoyage.

12. Procédé selon l'une quelconque des revendications 6 à 11, dans lequel la température élevée est au moins initialement à sensiblement la température de traitement.

13. Procédé selon l'une quelconque des revendications 6 à 12, dans lequel la température élevée est comprise dans la plage de 200°C à 800°C.

14. Procédé selon la revendication 13, dans lequel la température est comprise dans la plage de 400°C à 700°C.

15. Procédé selon l'une quelconque des revendications 6 à 14, dans lequel le gaz à teneur de fluor comprend un mélange de CF4 et d'02 dans les rapports respectifs de 80% pour 20% en volume.

16. Procédé selon l'une quelconque des revendications 6 à 15, dans lequel le débit du gaz à teneur en fluor est de 150 centimètres cubes standard par minute.

17. Procédé selon l'une quelconque des revendications 6 à 16, dans lequel l'étape de nettoyage au plasma est exécutée en utilisant une composante basse fréquence comprise entre 50 kHz et 450 kHz, et/ou une composante haute fréquence de 13,56 MHz.

18. Procédé selon l'une quelconque des revendications 6 à 17, dans lequel la plage de puissance du plasma est comprise entre 50W et 300W.

19. Procédé de nettoyage au plasma comprenant le placement d'un substrat en contact avec la surface supérieure de la première électrode dans une chambre de traitement au plasma de l'appareil de traitement au plasma selon l'une quelconque des revendications 1 à 5 ; la délivrance d'un ou de plusieurs gaz de traitement dans la chambre et la génération d'un plasma dans la chambre à partir du ou des gaz de traitement, au moyen des première et seconde électrodes de façon à traiter au plasma le substrat.

20. Procédé selon l'une quelconque des revendications 6 à 19, dans lequel le processus au plasma comprend un processus de dépôt ou de gravure.

21. Procédé selon l'une quelconque des revendications 6 à 20, dans lequel le dépôt est en un matériau électriquement isolant.
